**Europäisches Patentamt**

**European Patent Office**

**Office européen des brevets**

(19)

(11) Veröffentlichungsnummer : **0 258 284 B1**

(12) **EUROPÄISCHE PATENTSCHRIFT**

(45) Veröffentlichungstag der Patentschrift :
**22.04.92 Patentblatt 92/17**

(51) Int. Cl.⁵ : **H05K 3/00,** B05C 9/04,
**G03F 7/16**

(21) Anmeldenummer : **87900800.1**

(22) Anmeldetag : **22.01.87**

(86) Internationale Anmeldenummer :
**PCT/DE87/00026**

(87) Internationale Veröffentlichungsnummer :
**WO 87/04584 30.07.87 Gazette 87/17**

(54) **ANLAGE ZUM BEIDSEITIGEN BESCHICHTEN UND TROCKNEN VON LEITERPLATTEN OD. DGL.**

(30) Priorität : **27.01.86 DE 3602350**

(43) Veröffentlichungstag der Anmeldung :
**09.03.88 Patentblatt 88/10**

(45) Bekanntmachung des Hinweises auf die
Patenterteilung :
**22.04.92 Patentblatt 92/17**

(84) Benannte Vertragsstaaten :
**AT CH GB LI NL SE**

(56) Entgegenhaltungen :
**DE-A- 1 752 079**

(56) Entgegenhaltungen :
**DE-A- 3 047 578**
**FR-A- 2 399 877**
**US-A- 4 111 155**
**US-A- 4 228 582**

(73) Patentinhaber : **WEBER, Erich**
**Effnerstrasse 89**
**W-8000 München 81 (DE)**

(72) Erfinder : **WEBER, Erich**
**Effnerstrasse 89**
**W-8000 München 81 (DE)**

(74) Vertreter : **Konle, Tilmar, Dipl.-Ing.**
**Benderstrasse 23 a**
**W-8000 München 60 (DE)**

EP 0 258 284 B1

**Beschreibung**

Zum beidseitigen Anstreichen von Platten ist aus der DE-A-1 752079 bekannt, jede Platte auf einem Rollengang durch eine Beschichtungsvorrichtung zu transportieren und auf der einen Seite zu beschichten. Anschließend wird die einseitig beschichtete Platte durch eine Trocknungsvorrichtung transportiert, um die Beschichtung zu trocknen. Nach erfolgter Trocknung wird die Platte in einer Wendevorrichtung um 180° gewendet, so daß die andere, noch unbeschichtete Seite nach oben zeigt, während die getrocknete und damit belastbare Plattenseite auf dem Rollengang aufliegt. Nunmehr wird die andere Plattenseite in derselben Weise und in denselben Vorrichtungen wie zuvor die eine Plattenseite beschichtet und getrocknet. Abgesehen davon, daß eine derartige, sukzesive Behandlung beider Plattenseiten zeitaufwendig ist, besteht ein wesentlicher Nachteil im Falle der Beschichtung mit lichtempfindlichem Lack bei Leiterplatten darin, daß die bereits getrocknete Plattenseite während der Trocknung der anderen Plattenseite nochmals der Trocknung unterworfen wird.

Die Aufgabe der Erfindung besteht demgegenüber darin, beide Seiten einer Leiterplatte derselben thermischen Behandlung zu unterwerfen.

Diese Aufgabe wird erfindungsgemäß bei einem Verfahren gemäß den kennzeichnenden Merkmalen des Patentanspruchs 1 und bei Anlagen gemäß den kennzeichnenden Merkmalen der Patentansprüche 4 und 5 gelöst.

Vorteilhafte Weiterbildungen und Ausgestaltungen des erfindungsgemäßen Verfahrens ergeben sich aus den Patentansprüchen 2 und 3.

Vorteilhafte Ausgestaltungen und Weiterbildungen der erfindungsgemäßen Anlagen ergeben sich aus dem Patentanspruch 6.

Die Erfindung wird im folgenden anhand zweier Ausführungsformen in den Zeichnungen näher erläutert. Es zeigt:

Fig. 1 eine Draufsicht auf eine Beschichtungsanlage mit seitlicher Plattenzuführung und einer einzigen Beschichtungsvorrichtung, und

Fig. 2 eine Draufsicht auf eine alternative Beschichtungsanlage mit zwei Beschichtungsvorrichtungen und mit Plattenzuführung an einem Ende der Anlage.

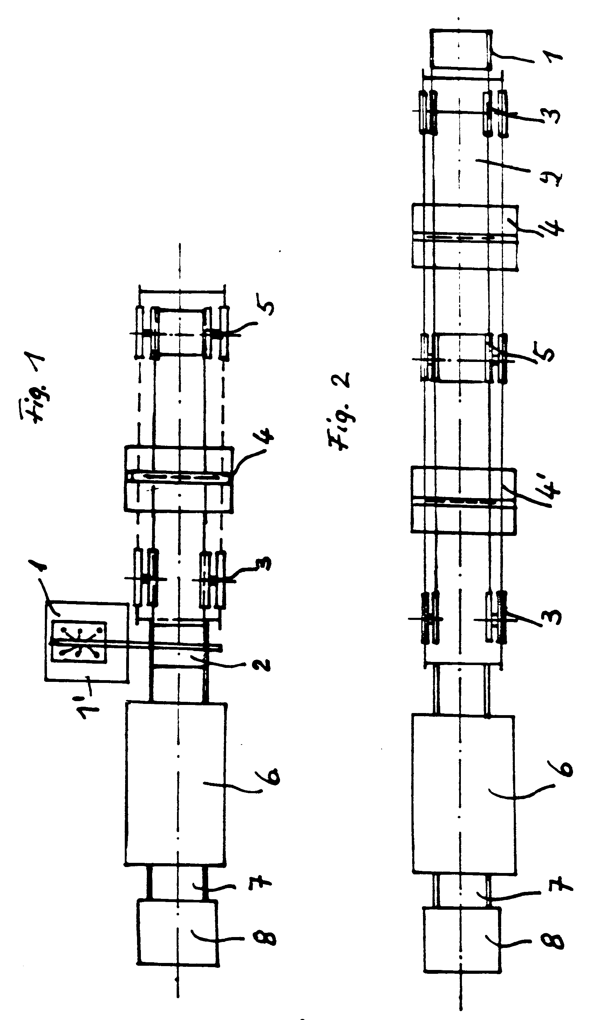

Bei der in Fig. 1 dargestellten Beschichtungsanlage wird von einer Platteneinlagestelle 1' eine Leiterplatte 1 von der Seite her einer Transportbahn 2 zugeführt und auf eine fahrbare Transportvorrichtung bzw. auf einen Transportschlitten 3 gelegt. Oer Transpartschlitten 3 hat eine Wendevorrichtung und eine seitliche Plattenhalterung. Damit fährt er durch den Gießfilm einer Beschichtungsvorrichtung 4, wodurch er die eine Seite der Leiterplatte 1 mit einer Beschirhtung versieht.

Dieser Transpartschlitten 3 mit der einseitig beschichteten Leiterplatte 1 wird auf der Transpartbahn gestoppt und in der Vorrichtung 5 gewendet. Dadurch kommt die noch nicht beschichtete Plattenseite der Leiterplatte nach oben.

In diesem Zustand fährt nun der Transportschlitten 3 zurück durch die gleiche Beschichtungsvorrichtung 4 bzw. durch den Gießfilm derselben, welcher die zweite Seite der Leiterplatte 1 beschichtet. Nunmehr sind beide Seiten der Leiterplatte 1 mit der gewünschten Beschichtung versehen, welche nicht beschädigt werden können, weil die Leiterplatte von der Haltevorrichtung des Transportschlittens 3 nur an den beiden äuBeren Rändern festgeklemmt ist.

Nunmehr wird die beidseitig beschichtete Leiterplatte auf der Transportbahn 2 in den Trockner 6 eingeführt. Beide Seiten der Leiterplatte trocknen darin gleichmäßig bei gleichen Temperaturverhältnissen. Auf diese Weise können eine Beschichtungsvorrichtung (Gießmaschine) und eine Trocknungsvorrichtunn eingespart werden. Im Anschluß an die Trocknungsvorrichtung 6 ist ein Auslaufband 7 vargesehen, das zu einem Abstapler 8 bzw. einer Kassette führt.

Bei der Anlage gemäß Fig. 2 wird die Leiterplatte 1 nicht von der Seite her, wie in Fig. 1, sondern am vorderen Ende der Transportbahn 2 der Anlage durch eine entsprechende Vorrichtung zugeführt. Auf dem Transport-schlitten 3 fährt die Leiterplatte 1 mit ihrer Haltevorrichtung durch eine erste Beschichtungsvorrichtung (Gießmaschine) 4 und bewegt sich dann weiter bis zu einer Wendevorrichtung 5. Dadurch gelangt die Leiterplatte mit ihrer beschichteten Seite nach unten, während die noch unbeschichtete Seite der Leiterplatte nach oben gelangt, In diesem Zustand fährt der Transpartschlitten mit der Leiterplatte durch die zweite Beschichtungsvorrichtung oder Gießmaschine 4'. Es sind jetzt beide Seiten der Laiterplatte 1 mit der Beschichtung versehen, und in diesem Zustand wird sie in die gemeinsame Trocknungsvorrichtung 6 eingeführt. Die Trocknung der Leiterplatte erfolgt darin wie bei der Anlage gemäß Fig. 1, von wo aus sie zu einer Ableitung oder Abstapelung oder an eine sonstige Stelle gebracht wird. Die Anlage gemäß Fig. 2 hat den Vorteil, daß sie keine seitlich vorstehenden Vorrichtungen hat wie bei Fig. 1.

**Patentansprüche**

1. Verfahren zum beidseitigen Beschichten von Leiterplatten mit flüssigem, lichtempfindlichem Lack, welcher nach dem Aufbringen getrocknet wird, bei dem

a) die Leiterplatten (1) zunächst durch eine Beschichtungsvorrichtung (4) transportiert und jeweils auf einer Seite beschichtet werden,

b) jede einseitig beschichtete Leiterplatte (1) bei weiterem Transport um 180° gewendet und anschließend auf der anderen Seite beschichtet wird, und

c) die Trocknung beider Seiten jeder Leiterplatte (1) in derselben Trocknungsvorrichtung (6) erfolgt,

wobei jede Leiterplatte (1) bei ihrem Transport nur an den beiden äußeren Rändern gehalten wird, daß die andere Seite jeder Leiterplatte (1) beschichtet wird, noch während die bereits beschichtete Seite ungetrocknet ist, und daß erst nach dem Beschichten der anderen Seite die Leiterplatte (1) durch die Trocknungsvorrichtung (6) transportiert wird, wo beide Seiten jeder Leiterplatte (1) gleichzeitig bei gleichen Temperaturverhältnissen getrocknet werden.

2. Verfahren nach Anspruch 1, dadurch gekennzeichnet, daß die Leiterplatten (1) von einer Seite (1') einer Transportbahn (2) zugeführt und jeweils auf einem fahrbaren Plattenhalter (3) abgelegt werden, welcher durch die Beschichtungsvorrichtung (4) geführt, einer Wendevorrichtung (5) zugeführt, in umgekehrter Richtung zurück und durch die gleiche Beschichtungsvorrichtung (4) hindurchgeführt sowie der Trocknungsvorrichtung (6) zugeführt wird (Fig. 1).

3. Verfahren nach Anspruch 1, dadurch gekennzeichnet, daß die Leiterplatten (1) einer Transportbahn (2) an einem Ende derselben zugeführt und auf einem fahrbaren Plattenhalter (3) abgelegt werden, welcher einer ersten Beschichtungsvorrichtung (4) zugeführt, in einer Wendevorrichtung (5) gewendet, durch eine zweite Beschichtungsvorrichtung (4') hindurchgeführt und der Trocknungsvorrichtung (6) zugeführt wird (Fig. 2).

4. Anlage zum beidseitigen Beschichten von Leiterplatten (1) mit flüssigem, lichtempfindlichem Lack, mit

a) einer Transportbahn (2) zum Transportieren der Leiterplatten (1) durch eine Beschichtungsvorrichtung (4), um die Leiterplatten (1) auf einer Seite nacheinander zu beschichten,

b) einer Wendevorrichtung (5) zum Wenden jeder einseitig beschichteten Leiterplatte (1) um 180° und zur Zunkehrung der Transportrichtung der Leiterplatte (1) und

c) einer Trocknungsvorrichtung (6) zum Trocknen beider beschichteten Leiterplattenseiten, **dadurch gekennzeichnet** , daß eine Halteeinrichtung (3) zum Halten jeder Leiterplatte (1) nur an den beiden äußeren Rändern während des Transports vorgesehen ist, daß die Wendevorrichtung (5) - in dert ursprünglichen Transportrichtung gesehen - hinter der Beschichtungsstation (4) angeordnet ist, und daß die Trocknungsvorrichtung (6) so angeordnet ist, daß sie von der Leiterplatte (1) erst nach erflogter beidseitiger Besdrichtung zum gleichzeitigen Trocknen beider Plattenseiten bei gleichen Temperaturverhältnissen durchlanfen wird (Fig. 1).

5. Anlage nach Anspruch 4, dadurch gekennzeichnet, daß anstelle einer einzigen Beschichtungsvorrichtung (4) zum Beschichten beider Leiterplattenseiten zwei getrennte Beschichtungsvorrichtungen (4 und 4') vorgesehen sind, zwischen denen die Wendevorrichtung (5) angeordnet ist und daß die Wendevorrichtung (5) die Transportrichtung der Leiterplatten (1) unbeeinflußt läßt.

6. Anlage nach Anspruch 4 oder 5, dadurch gekennzeichnet, daß als Halteeinrichtung ein fahrbarer Plattenhalter (3) vorgesehen ist.

**Claims**

1. Method for the coating on both sides of conductor plates with liquid light-sensitive varnish which is dried after the application, in which

a) the conductor plates (1) are conveyed through a coating apparatus (4) and respectively coated on one side,

b) each conductor plate (1) coated on one side, upon further conveying is turned 180° and then coated on the other side and

c) the drying of both sides of each conductor plate is effected in the same drying apparatus (6),

whereby each conductor plate (1) upon its conveying is held only at the two outer edges, that the other side of each conductor plate is coated whilst the already coated side is undried and only after the coating of the other side is the conductor plate (1) conveyed through the drying apparatus (6) where both sides of each conductor plate (1) are dried simultaneously at the same temperature conditions.

2. Method according to claim 1, characterised in that the conductor plates (1) are fed from one side (1') of a conveyor track (2) and respectively placed on a movable plate holder (3) which is led through the coating apparatus (4), fed to a turning apparatus (5), back in reversed direction and led through the same coating apparatus (4) as well as fed to the drying apparatus (6) (Fig. 1).

3. Method according to claim 1, characterised in that the conductor plates (1) are led to a conveyor track (2) at one end of same and placed on a movable plate holder (3) which is fed to a first coating apparatus (4), turned in a turning apparatus (5), led through a second coating apparatus (4') and fed to the drying apparatus (6) (Fig. 2).

4. Installation for the coating on both sides of conductor plates (1) with liquid light-sensitive varnish, with

a) a conveyor track (2) for the conveying of the conductor plates (1) through a coating apparatus (4) in order to coat the conductor plates (1) on one side one after the other,

b) a turning apparatus (5) for the turning of each conductor plate (1) coating on one side by 180° and for the reversing of the conveying apparatus of the conveyor plate (1) and

c) a drying apparatus (6) for the drying of both coated conductor plate sides, characterised in that a holding device (3) is provided for the holding of each conductor plate (1) only on the two outer edges during the conveying, that the turning apparatus (5) - seen in the original conveying direction - is disposed behind the coating station (4), and that the drying apparatus (6) is so arranged that it is passed through by the conductor plate (1) only after the coating on both sides has been effected for the simultaneous drying of both of the plates at the same temperature conditions (Fig. 1).

5. Installation according to claim 4, characterised in that instead of a single coating apparatus (4) for the coating of both sides of the conductor plates, two separate coating apparata (4 and 4') are provided between which is disposed a turning apparatus (5) and that the turning apparatus (5) leaves the conveying apparatus of the conductor plates (1) unaffected.

6. Installation according to claim 4 or 5, characterised in that as holding device a movable plate holder (3) is provided.

## Revendications

1. Procédé destiné à revêtir sur leurs deux côtés, ou faces, des cartes de circuits imprimés à l'aide d'un vernis fluide sensible à la lumière, qui est séché après son application, dans lequel,

a) les cartes de circuits imprimés (1) sont d'abord transportées à travers un dispositif de revêtement (4) et sont revêtues chacune sur une face,

b) chaque carte de circuit imprimé (1) revêtue sur une face est tournée de 180° lors d'un transport ultérieur et est ensuite revêtue sur l'autre face,

c) le séchage des deux faces de chaque carte de circuit imprimé (1) est réalisé dans le même dispositif de séchage (6), chaque carte de circuits imprimés (1) n'étant maintenue pendant son transport que sur les deux bords extérieurs, l'autre face de chaque carte de circuit imprimé étant revêtue pendant que la face déjà revêtue n'a pas encore été séchée, et la carte de circuit imprimé n'étant transportée à travaers le dispositif de séchage (6) qu'après revêtement de l'autre face, les deux faces de chaque carte de circuit imprimé (1) étant séchées simultanément dans des conditions égales de température.

2. Procédé selon la revendication 1, caractérisé en ce que les cartes de circuits imprimés (1) sont amenées depuis un côté (1') d'une voie de transport (2) et sont respectivement déposées sur un porte-cartes mobile (3), qui est guidé à travers le dispositif de revêtement (4), est amené à un dispositif de retournement (5), est guidé en retour dans le sens inverse et à travers le même dispositif de revêtement (4) et amené en outre au dispositif de séchage (6) (Fig. 1).

3. Procédé selon la revendication 1, caractérisé en ce que les cartes de circuits imprimés (1) sont amenées à une voie de transport (2) à une extrémité de celle-ci et sont disposées sur un porte-cartes mobile (3) qui est amené à un premier dispositif de revêtement (4), tourné dans un dispositif de retournement (5), quidé à travers un deuxième dispositif de revêtement (4') et amené au dispositif de séchage (6) (Fig. 2).

4. Installation destinée à revêtir des cartes de circuits imprimés (1) sur leurs deux faces à l'aide d'un vernis fluide, sensible à la lumière, comprenant

a) une voie de transport (2) pour transporter les cartes de circuits imprimés (1) à travers un dispositif de séchage (4), pour revêtir les cartes de circuits imprimés (1) l'une après l'autre sur une face,

b) un dispositif de retournement (5) pour retourner de 180° chaque carte de circuit imprimé (1) revêtue sur une face et pour inverser le sens de transport de la carte de circuit imprimé (1) et

c) un dispositif de séchage (6) pour le séchage des deux faces revêtues de la carte de circuit imprimé caractérisé en ce qu'un dispositif de maintien (3) est prévu pour tenir chaque carte de circuit imprimé (1) seulement sur les deux bords extérieurs pendant le transport, en ce que le dispositif de retournement (5) est disposé, en vue selon le sens de transport d'origine, derrière la station de revêtement (4) et en ce que le dispositif de séchage (6) est disposé de telle manière qu'il n'est parcouru par la carte de circuit imprimé (1) qu'après revêtement sur les deux faces en vue d'un séchage simultané des deux faces de carte dans des conditions égales de température (Fig. 1).

5. Dispositif selon la revendication 4, caractérisé en ce qu'il est prévu pour le revêtement, au lieu d'un dispositif de revêtement unique (4), deux dispositifs de revêtement séparés (4 et 4') entre lesquels est disposé le dispositif de retournement (5) et en ce que le dispositif de retournement (5) laisse inchangée la direction de transport des cartes de circuits imprimés (1).

6. Installation selon la revendication 4 ou 5, caractérisée en ce qu'un porte-cartes mobile (3) est prévu comme dispositif de maintien.

EP 0 258 284 B1

Fig. 1

Fig. 2